# EUROPEAN PATENT APPLICATION

(11) **EP 1 435 696 A1**
(43) Date of publication of application: **07.07.2004**
(21) Application number: 01981213.0
(22) Date of filing: 16.10.2001
(51) Int. Cl.: H03M 13/13, H03M 13/35

(54) **METHOD FOR TRANSMITTING A DIGITAL MESSAGE AND SYSTEM FOR CARRYING OUT SAID METHOD**

(30) Priority: 22.05.2001 RU 2001113567
(71) Applicant: MORTON FINANCE S.A., Road Town Tortola, British Virgin Island (VG)
(72) Inventor: Plotnikov, Andrey Alexejevich, Vyborg, Leningradskaya obl. 188800 (RU); Akajev, Said Kakhsurujevich, Vyborg, Leningradskaya obl. 188800 (RU); Velikokhatsky, Victor Fyodorovich, Vyborg, Leningradskaya obl. 188800 (RU); Lysy, Vadim Yegenievich, Vyborg, Leningradskaya obl. 188800 (RU)
(74) Representative: UEXKÜLL & STOLBERG
(86) International application number: PCT/RU2001/000417
(87) International publication number: WO 2002/095953

(57) **Abstract**

The invention relates to telecommunications, in particular to methods and means for transmitting digital messages and can be used for transmitting information through wire channels and telecommunication channels using electromagnetic waves. The use of said channels is simplified by excluding multiplication and division operators from the coding and a decoding process. Said invention makes it possible to transmit any messages from elements of Abelian group including code words whose elements are matrixes, polynomials, numbers of mixed-base notation and nonpositional notation. The inventive encoder comprises a driver clock (7), a function g² calculator (8), a pulse generator (9) having recurrent frequency of f(k+1)/k, a pulse recurrent frequency doubler (10), a ring counter (11) up to k, an adder-accumulator of elements of Abelian group (12), a key (13), a ring counter (14) up to (2k+1), an AND component (15), a main memory unit (16), a key (17), a trigger (18), a main memory unit (19) and a ring counter (20) up to (k+1). The inventive decoder comprises a driver clock (21), an adder-accumulator of elements of Abelian group (22), a pulse generator (23) having recurrent frequency of fk(k+1)/k, a pulse recurrent frequency doubler (24), a ring counter (25) up to (k+1), a key (26), a main memory unit (27), a key (28), an AND component (29), a ring counter up to [2(k+1)+1] (30), an identification unit provided with a single element of Abelian group (31), a trigger (32), a main memory unit (33) a key (34), a ring counter (35) up to k.

## Description

### FIELD OF THE INVENTION

This invention relates to telecommunications, in particular to methods and means for transmitting digital messages, and can be used for transmitting information through wire channels and telecommunication channels using electromagnetic waves.

### DESCRIPTION OF THE PRIOR ART

A method for transmitting digital message consisting of additive Abelian group elements is known which comprises consecutive steps of encoding digital message, its modulation, its transmission to a communication channel, demodulation of the received signal and its decoding [1].

A system for transmitting digital messages consisting of additive Abelian group elements is known which comprises consecutively connected at the transmitting side an encoder, a modulator and a transmitter and consecutively connected at the receiving side a receiver, a demodulator and a decoder [1].

The known method and system are rather complicated in realization because they use four arithmetic operations for the encoding and decoding process.

### DESCRIPTION OF THE INVENTION

The technical result achieved when using the proposed method and system consists of simplifying their realization by excluding multiplication and division operations from the encoding and decoding process. This provides an opportunity for transmitting any message consisting of Abelian group elements, in particular code words, whose elements are matrixes, polynomials, numbers of mixed-base notation and non-positional notation. The codes organized in accordance with the proposed rules belong to the class of systematic linear block codes.

The above-mentioned technical result is achieved in that in a method for transmitting a digital message consisting of additive Abelian group elements which comprises consecutive steps of encoding the message, its modulation, its transmission into a communication channel, demodulation of the received signal and its decoding, the encoding is done according to the rule Yₙ=Xₖ⊗G, where
Xₖ is vector-row of the initial message consisting ofk information elements,
Yₙ is vector-row of the encoded message consisting of k information and one check elements,
G is generating matrix of operations which consists of k rows and (k+1) columns and is produced from a k×k matrix, with operations g⁰ at the diagonal and operations g¹ at other positions, and an additional column which is added to the kxk matrix at its right and which contains a sequence of operations g⁰ or operations g² at all positions, or a matrix obtained from said generating matrix of operations by rearranging its rows and/or columns,
⊗ is operation of generalized matrix multiplication according to the rule yⱼ=^{⊕}Σg^{v}ᵢⱼ(xᵢ) for j≤k and yⱼ=g²[^{⊕}Σg^{v}ᵢⱼ(xᵢ)] for j=k+1, if the additional column contains a sequence of operations g⁰, or according to the rule yⱼ=^{⊕}Σg^{v}ᵢⱼ(xᵢ), if the additional column contains a sequence of operations g², where
yⱼ is j-th element of the vector-row of the encoded message,
^{⊕}Σ g^{v}ᵢⱼ(xᵢ) = g^{v}₁ⱼ(x₁) ⊕ g^{v}₂ⱼ(x₂) ⊕ ... ⊕ g^{v}ₖⱼ(xₖ),
⊕ is operation for summing up Abelian group elements,
g^{v}ᵢⱼ(xᵢ) is operation g^{v} for element xᵢ according to the rule for ij-th matrix element,
v = [0, 2], i=[1, k], j=[1, k+1],
g⁰ = xᵢ ⊕ e, g¹ = xᵢ ⊕ (-xᵢ), g² = xᵢ ⊕ (-xᵢ) ⊕ (-xᵢ),
e is unity element of Abelian group,
and the decoding of the demodulated message Y'ₙ is done by excluding from the vector-row Y'ₙ of the element which corresponds by its number to the additional column of the generating matrix of operations G under the provision that H⊗Y'ₙ^{T}= e, where
Y'ₙ^{T} is transposed vector-row Y'ₙ, and
H is 1×(k+1) check matrix of operations produced by transposition of the additional column, by adding operation g⁰ to its right, if the additional column contains a sequence of operations g⁰, and by rearranging the columns identically to the column rearrangement of the generating matrix of operations, or in the same way save for exchanging operations g² for operations g⁰, if the additional column contains a sequence of operations g².

The above-mentioned technical result is also achieved by the fact that under the condition that the message elements belong to a ring with unity, operation g⁰ is multiplication by unity, operation g¹ is multiplication by zero and operation g² is multiplication by minus unity.

The above-mentioned technical result is also achieved by the fact that under the condition that the message elements belong to a residue class ring by modulo q, where q is a natural number, operation ⊕ is the operation of summing by modulo q.

The above-mentioned technical result is also achieved by providing that in a system for transmitting a digital message consisting of additive Abelian group elements which comprises consecutively connected at the transmitting side an encoder, the input of which corresponds to the system's input, a modulator and a transmitter, and consecutively connected at the receiving side a receiver, a demodulator and a decoder, the output of which corresponds to the system's output, the encoder is in a form capable of performing the algorithm Yₙ=Xₖ⊗G, where
Xₖ is vector-row of the initial message consisting of k information elements,
Yₙ is vector-row of the encoded message consisting of k information and one check elements,
G is generating matrix of operations which consists of k rows and (k+1) columns and is produced from a k×k matrix, with operations g⁰ at the diagonal and operations g¹ at other positions, and an additional column which is added to the kxk matrix at its right and which contains a sequence of operations g⁰ or operations g² at all positions, or a matrix obtained from said generating matrix of operations by rearranging of its rows and/or columns,
⊗ is operation of generalized matrix multiplication according to the rule yⱼ=^{⊕}Σg^{v}ᵢⱼ(xᵢ) for j≤k and yⱼ=g²[^{⊕}Σg^{v}ᵢⱼ(xᵢ)] for j=k+1, if the additional column contains a sequence of operations g⁰, or according to the rule yⱼ=^{⊕}Σg^{v}ᵢⱼ(xᵢ), if the additional column contains a sequence of operations g², where
yⱼ is j-th element of the vector-row of the encoded message,
^{⊕}Σ g^{v}ᵢⱼ(xᵢ) = g^{v}₁ⱼ(x₁) ⊕ g^{v}₂ⱼ(x₂) ⊕ ... ⊕ g^{v}ₖⱼ(xₖ),
⊕ is operation for summing up Abelian group elements,
g^{v}ᵢⱼ(xᵢ) is operation g^{v} for element xᵢ according to the rule for a ij-th matrix element,
v = [0, 2], i=[1, k], j=[1, k+1],
g⁰ = xᵢ ⊕ e, g¹ = xᵢ ⊕ (-xᵢ), g² = xᵢ ⊕ (-xᵢ) ⊕ (-xᵢ),
e is unity element of Abelian group,
and the decoder is in a form which provides for the exclusion from the vector-row Y'ₙ of the element which corresponds by its number to the additional column of the generating matrix of operations G under the provision that H⊗Y'ₙ^{T}= e, where
Y'ₙ^{T} is transposed vector-row Y'ₙ,
H is 1×(k+1) check matrix of operations generated by transposition of the additional column, by adding operation g⁰ at its right, if the additional column contains a sequence of operations g⁰, and by rearranging the columns identically to the column rearrangement of the generating matrix of operations, or in the same way save for exchanging operations g² for operations g⁰, if the additional column contains a sequence of operations g².

The above-mentioned technical result is also achieved by providing that the encoder contains:
- the first operative memory unit, k outputs of which are connected to the corresponding first k information inputs of the second operative memory unit, the output of which forms the encoder output,
- consecutively connected a function g² calculator, the first adder for summing up Abelian group elements, the output of which is connected to its second input, the first switch, the output of which is connected to the (k+1)-th information input of the second operative memory unit,
- consecutively connected the first pulse shape forming unit and the first ring counter up to k, the overflow output of which is connected to the control input of the first switch and to the reset input of the first operative memory unit,
- consecutively connected a pulse generator having recurrent frequency of f(k+1)/k, the second switch and the first ring counter up to (k+1), the information output of which is connected to the address input of the second operative memory unit,
- the first gate AND, the output of which is connected to the control input of the second switch,
- the first trigger, the output of which is connected to the direct input of the first gate AND, the inverting input of which is connected to the overflow output of the first ring counter up to (k+1) and to the reset input of the first trigger,
- consecutively connected the first pulse recurrent frequency doubler, the input of which is connected to the output of the pulse generator having recurrent frequency of f(k+1)/k, and a ring counter up to (2k+1), the overflow output of which is connected to the counting input of the first trigger,
and that the combined information inputs of the first operative memory unit and the function g² calculator, the start input of the pulse shape forming unit and the synchronization input of the pulse generator having recurrent frequency of f(k+1)/k together form the encoder input, whereby f is the recurrent frequency of the code word elements in a digital message.

The above-mentioned technical result is also achieved by providing that the decoder contains:
- the third operative memory unit, (k+1) outputs of which are connected to the corresponding first (k+1) information inputs of the fourth operative memory unit, the output of which forms the decoder output,
- consecutively connected the second adder for summing up Abelian group elements, the output of which is connected to its second input, the third switch, the identification unit for identifying the correspondence to unity element of Abelian group, and the fourth switch, the output of which is connected to the address input of the fourth operative memory unit,
- consecutively connected the second pulse shape forming unit and the second ring counter up to (k+1), the overflow output of which is connected to the control input of the third switch and to the reset input of the third operative memory unit,
- consecutively connected a pulse generator having recurrent frequency of fk/(k+1), the fifth switch, and the second ring counter up to k, the information output of which is connected to the information input of the fourth switch,
- the second gate AND, the output of which is connected to the control input of the fifth switch,
- the second trigger, the output of which is connected to the direct input of the second gate AND, an inverting input of which is connected to the overflow output of the second ring counter up to k and to the reset input of the second trigger,
- consecutively connected the second pulse recurrent frequency doubler, the input of which is connected to the output of the pulse generator having recurrent frequency of fk/(k+1), and the ring counter up to [2(k+1)+1], the overflow output of which is connected to the counting input of the second trigger,
and that the combined information inputs of the third operative memory unit and the second adder for summing up Abelian group elements, the start input of the second pulse shape forming unit and the synchronization input of the pulse generator having recurrent frequency of fk/(k+1) together form the decoder input, whereby f is the recurrent frequency of the code word elements in a digital message.

### BRIEF DESCRIPTION OF THE FIGURES

Fig. 1 illustrates an example of coding and decoding of an individual message.

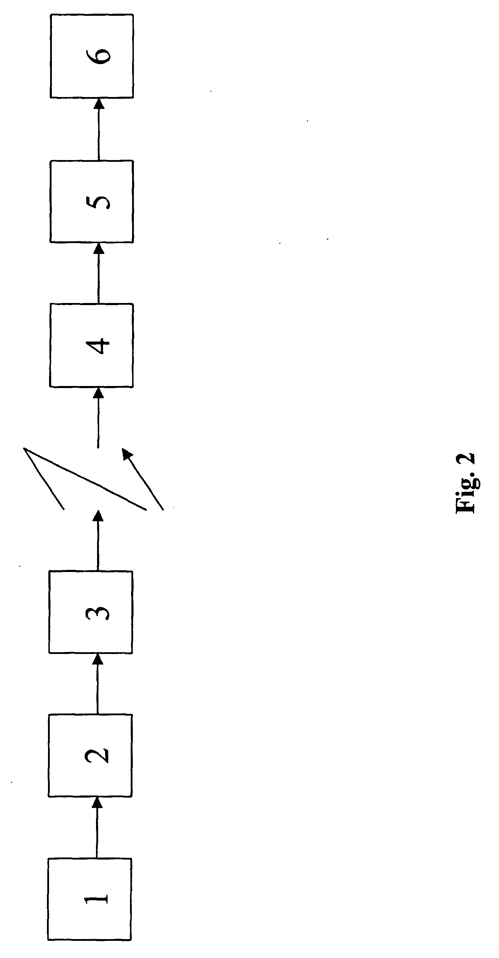

Fig. 2 illustrates a functional electrical block scheme of a system for transmitting a digital message.

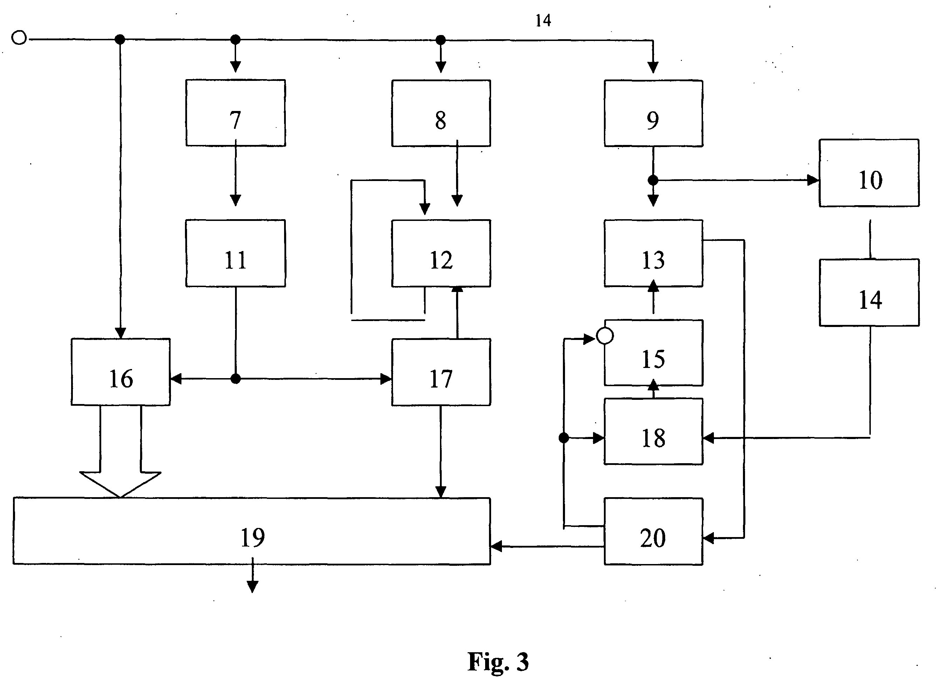

Fig. 3 illustrates a functional electrical block scheme of an encoder.

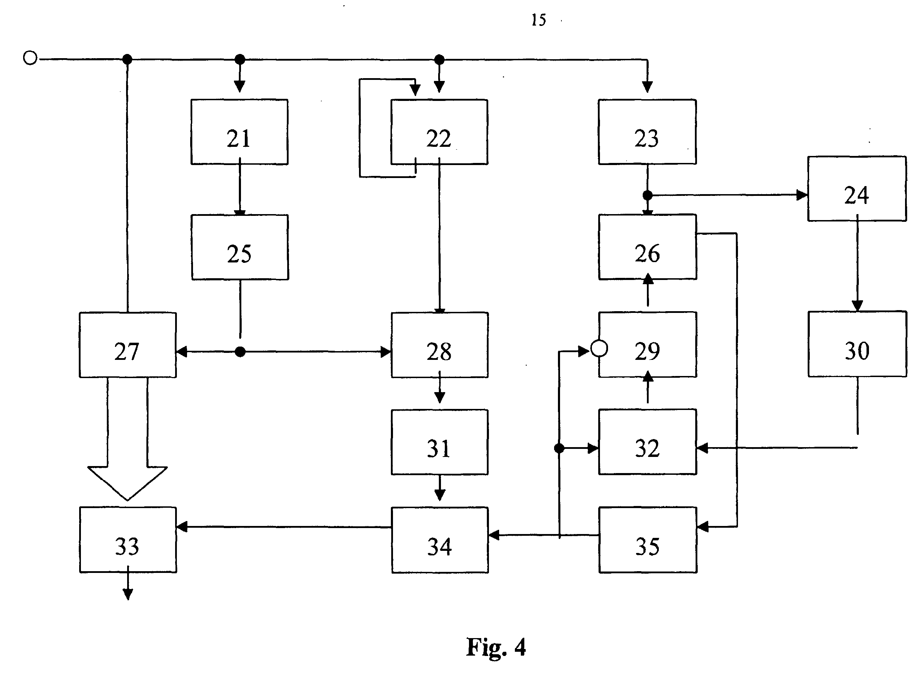

Fig. 4 illustrates a functional electrical block scheme of a decoder.

A system for transmitting a digital message consists of encoder 1, modulator 2, transmitter 3, receiver 4, demodulator 5 and decoder 6.

Encoder 1 comprises a first pulse shape forming unit 7, a function g² calculator 8, a pulse generator 9 having recurrent frequency of f(k+1)/k, a first pulse recurrent frequency doubler 10, a first ring counter 11 up to k, a first adder-accumulator 12 for Abelian group elements, a second switch 13, a ring counter 14 up to (2k+1), a first gate AND 15, a first operative memory unit 16, a first switch 17, a first trigger 18, a second operative memory unit 19 and a first ring counter 20 up to (k+1).

Decoder 6 comprises a second pulse shape forming unit 21, a second adder-accumulator 22 for summing up Abelian group elements, a pulse generator 23 having recurrent frequency of fk/(k+1), a second pulse recurrent frequency doubler 24, a second ring counter 25 up to (k+1), a fifth switch 26, a third operative memory unit 27, a third switch 28, a second gate AND 29, a ring counter 30 up to [2(k+1)+1], an identification unit 31 for identifying the correspondence to unity element of Abelian group, a second trigger 32, a fourth operative memory unit 33, a fourth switch 34 and a second ring counter 35 up to k.

### DESCRIPTION OF THE PREFERRED EMBODIMENT

The method for transmitting a digital message according to the invention is realized as follows:

A generating matrix of operations G with k rows and (k+1) columns is produced. It consists of a kxk matrix with operations g⁰ at its diagonal and operations g¹ at other positions and an additional column which is added to said kxk matrix at its right and consists of a sequence of operations g⁰ or operations g² at all positions. It is also possible to use a generating matrix of operations produced from said generating matrix of operations by rearranging its rows and/or columns. The resulting generating matrix of operations is a matrix formed not of numbers, as usual matrixes, but of instructions to conduct a certain operation when an interaction with this element of the generating matrix of operations takes place.

Adding of an additional column is done in order to introduce into a message to be transmitted of check elements which serve for detecting errors in the received message in cases when the error is generated in the process of message transmission through a communication channel.

A generated digital message Xₖ is encoded by generalized matrix multiplication of the vector-row Xₖ by the generating matrix of operations G.

The procedure of the newly introduced operation of generalized matrix multiplication is similar to the procedure of usual matrix multiplication because it is performed in the same order, namely: paired interaction operations are done for the i-th element of the vector-row Xₖ and every ij-th element (which is situated at the crossing of the i-th row and the j-th column) of the operation matrix G and then the results of all j operations are summed up thus producing the j-th element of the vector-row Yₙ. Thereby, every of the above-mentioned operations which is required for the operation of generalized matrix multiplication is a summing operation in accordance with the rules formulated for elements of the Abelian group [2, p. 140] to which the elements of the generated digital message Xₖ consisting of k information elements belong. Operations g^{v} (g⁰, g¹ and g²) are summing operations with unity element of the group [2, p. 139], summing operations with the inverse element of the group [2, p. 140] and two-fold summing operations with the inverse element of the group, respectively.

The encoded message is modulated and transmitted to a communication channel.

The received message is demodulated and decoded. Decoding is done by the operation of generalized matrix multiplication of a check matrix H by the transposed vector-row Y'ₙ^{T}.

The 1×n check matrix of operations H is produced by transposing of an additional matrix by adding operation g⁰ to its right, if the additional column consists of a sequence of operations g⁰, or in the same way save for exchanging operations g² for g⁰, if the additional column consists of a sequence of operations g², and by rearranging the columns in the same way as column rearrangement was done for the generating matrix of operations (if the generating matrix of operations was produced by column rearrangement).

If the value obtained as a result of the multiplication equals unity element of the group (indicating the absence of errors in the received message), the element with a number corresponding to the number of the additional column in the generating matrix of operations G is excluded from the vector-row Y'ₙ; so that the check element inserted into the message during the process of encoding is discarded.

If the message elements belong to a ring with unity, which is an individual case of additive Abelian group, operations g⁰ transform into the operation of multiplication by unity, operations g¹ transform into the operation of multiplication by zero and operations g² transform into the operations of multiplication by minus unity.

If message elements belong to a residue class ring by modulo q, which is an individual case of a ring with unity, the operation ^{⊕}Σ transforms into the operation of summing by modulo q.

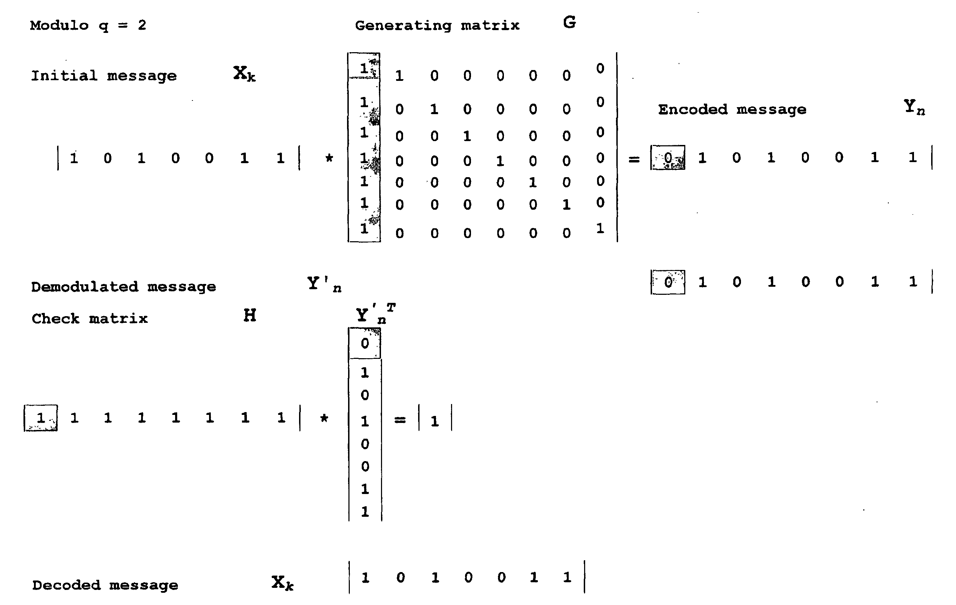

Fig. 1 illustrates an example of transmitting message Xₖ consisting of seven binary elements. A generating matrix of operations G is produced according to the above-mentioned rule. An additional column is inserted in the first position. After generalized matrix multiplication of the vector-row Xₖ by the matrix G, the encoded message vector-row Yₙ with a check element in the first position is generated.

The demodulated message Y'ₙ is received without errors. Therefore, the result of the generalized matrix multiplication of the check matrix H by the transposed vector-row Y'ₙ^{T} is unity element of the group. The decoding, i.e. extracting the elements of the original message, is then done by discarding the check element.

The system for transmitting a digital message according to the invention operates as follows:

Each element of the generated digital message Xₖ which consists of a sequence of code words with a size of k elements each, once reached the input of encoder 1 enters the information inputs of first operative memory unit 16 and calculator 8, triggers first pulse shape forming unit 7 and synchronizes pulse generator 9.

The pulse from the output of first pulse shape forming unit 7 triggers first ring counter 11. While first ring counter 11 counts pulses at its input, the elements of the code word are being stored in the corresponding cells of first operative memory unit 16 whereas calculator 8 converts the message elements according to the rule g².

The results of the conversion of the message elements subsequently enter the input of first adder-accumulator 12, where each subsequent converted element is summed up with the sum of the previous elements according to the rule for summing Abelian group elements, thus forming a check element for insertion into the code word to be transmitted.

After the k-th element of the code word enters the input of first ring counter 11, a pulse is formed at its overflow output, which opens the first switch 17, and transfers - by resetting first operative memory unit 16 - the information from the outputs of first operative memory unit 16 to the first k memory cells of second operative memory unit 19 and from the outputs of the first adder 12 to the (k+1)-th memory cell of second operative memory unit 19, respectively.

The pulses from the output of the generator 9 having recurrent frequency which is (k+1)/k times higher than the recurrent frequency of the code word elements, enter the information input of second switch 13, which, being originally in a closed state, does not transfer them to the input of first ring counter 20.

The same pulses enter the input of first frequency doubler 10, which doubles the recurrent frequency of the incoming pulses, and are then transferred from its output to the input of ring counter 14. With the entry of the (2k+1)-th pulse at the input of ring counter 14 (approximately in the middle of the time interval between the entry at the input of encoder 1 of the last element of the current code word and the first element of the next code word), a pulse from its overflow enters the counting input of first trigger 18, thereby changing its state.

The voltage signal "logical unity" formed at the output of first trigger 18 is transferred to the direct input of first gate AND 15. Since first ring counter 20 has not yet begun to count, the voltage signal "logical zero" is kept at its overflow output and consequently the voltage signal "logical unity" will appear at the output of first gate AND 15 which opens second switch 13.

The pulses from the output of generator 9 will begin to enter the input of first ring counter 20; and as a result thereof, a code will appear at its information output which will change with every next counted pulse. After entering the address input of second operative memory unit 19, this code will initiate an information reset of the memory cell having the same sequential number as the pulse counted by first ring counter 20, and k information and one check element of the code word will be sequentially transferred to the input of modulator 2.

After the n-th pulse enters the input of first ring counter 20, the voltage signal "logical unity" will form at its overflow output which will change the state of first trigger 18; and the voltage signal "logical zero" will appear at the output of first gate AND 15 which will close first switch 13 and stop the income of pulses from the output of generator 9 to the input of first ring counter 20, thus making it ready for the next operation cycle.

A modulated message from the output of modulator 2 enters the input of transmitter 3 and proceeds to a communication channel.

The received message, after being transferred through receiver 4, is demodulated in demodulator 5 and enters the input of decoder 6.

Each element of the received code word which enters the input of decoder 6 enters the information inputs of third operative memory unit 27 and second adding unit 22, triggers second pulse shape forming unit 21 and synchronizes generator 23. The pulse from the output of second pulse shape forming unit 21 triggers second ring counter 25. Whereas second ring counter 25 counts pulses entering its input, the elements of the code word are stored in the corresponding cells of third operative memory unit 27; and second adder-accumulator 22 determines the sum of all elements of the code word at its input according to the rule of summing Abelian group elements.

After the (k+1)-th element of the code word enters the input of second ring counter 25, a pulse is formed at its overflow output which - by opening third switch 28 and resetting third operative memory unit 27 - transfers the information from its outputs to the memory cells of fourth operative memory unit 33 and from the outputs of second accumulating unit 22 to identification unit 31, respectively. If the sum at the input of identification unit 31 equals unity element of Abelian group, the voltage signal "logical unity" enters the control input of fourth switch 34 and opens it.

The pulses from the output of generator 23 having recurrent frequency which is k/(k+1) times lower than the recurrent frequency of the code word elements, enter the information input of fifth switch 26, which - being originally in a closed state - does not transfer these pulses to the input of second ring counter 35.

The same pulses enter the input of second frequency doubler 24, which doubles the recurrent frequency of the incoming pulses, and are then transferred from its output to the input of second ring counter 30. With the entry of the [2(k+1)+1]-th pulse at the input of ring counter 30 (approximately in the middle of the time interval between the entry at the input of decoder 6 of the last element of the current code word and the first element of the next code word), a pulse from its overflow output enters the counting input of second trigger 32, thereby changing its state.

The voltage signal "logical unity" formed at the output of second trigger 32 enters the direct input of second gate AND 29. Since second ring counter 35 has not yet begun to count, the voltage signal "logical zero" is kept at its overflow output and consequently the voltage signal "logical unity" will appear at the output of second gate AND 29 which opens fifth switch 26.

The pulses from the output of generator 23 will begin to enter the input of second ring counter 35; and as a result thereof, a code will appear at its information output, which will change with every next counted pulse. This code will pass through the already opened fourth switch 34 and - by entering the address input of fourth operative memory unit 33 - will initiate information reset of the cell with a sequential number corresponding to the number of the pulse counted by second ring counter 35; and k information elements of the code word will be sequentially transferred to the decoder output, i.e. to the user. The check element will remain, since not required, in the (k+1)-th memory cell of fourth operative memory unit 33 and will be replaced therein by the check element of the next code word.

After the k-th pulse enters the input of second ring counter 35, the voltage signal "logical unity" will form at its overflow output which will change the state of second trigger 32; and the voltage signal "logical zero" will appear at the output of second gate AND 29 which will close fifth switch 26 and stop the income of pulses from the output of generator 23 to the input of second ring counter 35, thus making it ready for the next operation cycle.

### LITERATURE

1. J. Clark, J. Cane. Coding with error correction in digital communication systems, from English by S. I. Gelfand, ed. B. S. Tsybakov, Issue 28, Moscow, Publisher "Radio i svyaz", 1987. p.p. 9-18, fig 1.2.
2. A. I. Kostrikin, Introduction into algebra, Moscow, Publisher "Nauka", 1977.

## Claims

1. Method for transmitting a digital message consisting of additive Abelian group elements, which method comprises consecutive steps of encoding the message, its modulation, its transmission into a communication channel, demodulation of the received signal and its decoding, **characterized in that**
the encoding is done according to the rule Yₙ=Xₖ⊗G, where
Xₖ is vector-row of the initial message consisting of k information elements,
Yₙ is vector-row of the encoded message consisting of k information and one check elements,
G is generating matrix of operations which consists of k rows and (k+1) columns and is produced from a k×k matrix, with operations g⁰ at the diagonal and operations g¹ at other positions, and an additional column which is added to the kxk matrix at its right and which contains a sequence of operations g⁰ or operations g² at all positions, or a matrix obtained from said generating matrix of operations by rearranging of its rows and/or columns,
⊗ is operation of generalized matrix multiplication according to the rule yⱼ=^{⊕}Σg^{v}ᵢⱼ(xᵢ) for j≤k and yⱼ=g²[^{⊕}Σg^{v}ᵢⱼ(xᵢ)] for j=k+1, if the additional column contains a sequence of operations g⁰, or according to the rule yⱼ=^{⊕}Σg^{v}ᵢⱼ(xᵢ), if the additional column contains a sequence of operations g², where
yⱼ is j-th element of the vector-row of the encoded message,
^{⊕}Σ g^{v}ᵢⱼ(xᵢ) = g^{v}₁ⱼ(x₁) ⊕ g^{v}₂ⱼ(x₂) ⊕ ... ⊕ g^{v}ₖⱼ(xₖ),
⊕ is operation for summing up Abelian group elements,
g^{v}ᵢⱼ(xᵢ) is operation g^{v} for element xᵢ according to the rule for a ij-th matrix element,
v = [0, 2], i=[1, k], j=[1, k+1],
g⁰ = xᵢ ⊕ e, g¹ = xᵢ ⊕ (-xᵢ), g² = xᵢ ⊕ (-xᵢ) ⊕ (-xᵢ),
e is unity element of Abelian group,
and the decoding of the demodulated message Y'ₙ is done by excluding from the vector-row Y'ₙ of the element which corresponds by its number to the additional column of the generating matrix of operations G under the provision that H⊗Y'ₙ^{T}= e, where
Y'ₙ^{T} is transposed vector-row Y'ₙ, and
H is 1×(k+1) check matrix of operations generated by transposition of the additional column, by adding operation g⁰ at its right, if the additional column contains a sequence of operations g⁰, and by rearranging the columns identically to the column rearrangement of the generating matrix of operations, or in the same way save for exchanging operations g² for operations g⁰, if the additional column contains a sequence of operations g².

2. The method according to claim 1, **characterized in that** under the condition that the message elements belong to a ring with unity, operation g⁰ is multiplication by unity, operation g¹ is multiplication by zero and operation g² is multiplication by minus unity.

3. The method according to claim 1 or 2, **characterized in that** under the condition that the message elements belong to a residue class ring by modulo q, where q is a natural number, operation ⊕ is the operation of summing by modulo q.

4. A system for transmitting a digital message consisting of additive Abelian group elements, which system comprises consecutively connected at the transmitting side an encoder, the input of which corresponds to the system's input, a modulator and a transmitter, and consecutively connected at the receiving side a receiver, a demodulator and a decoder, the output of which corresponds to the system's output, **characterized in that**
the encoder is in a form capable of performing the algorithm Yₙ=Xₖ⊗G, where
Xₖ is vector-row of the initial message consisting of k information elements,
Yₙ is vector-row of the encoded message consisting of k information and one check elements,
G is generating matrix of operations which consists of k rows and (k+1) columns and is produced from a k×k matrix, with operations g⁰ at the diagonal and operations g¹ at other positions, and an additional column which is added to the kxk matrix at its right and which contains a sequence of operations g⁰ or operations g² at all positions, or a matrix obtained from said generating matrix of operations by rearranging of its rows and/or columns,
⊗ is operation of generalized matrix multiplication according to the rule yⱼ=^{⊕}Σg^{v}ᵢⱼ(xᵢ) for j≤k and yⱼ=g²[^{⊕}Σg^{v}ᵢⱼ(xᵢ)] for j=k+1, if the additional column contains a sequence of operations g⁰, or according to the rule yⱼ=^{⊕}Σg^{v}ᵢⱼ(xᵢ), if the additional column contains a sequence of operations g², where
yⱼ is j-th element of the vector-row of the encoded message,
^{⊕}Σ g^{v}ᵢⱼ(xᵢ) = g^{v}₁ⱼ(x₁) ⊕ g^{v}₂ⱼ(x₂) ⊕ ... ⊕ g^{v}ₖⱼ(xₖ),
⊕ is operation for summing up Abelian group elements,
g^{v}ᵢⱼ(xᵢ) is operation g^{v} for element xᵢ according to the rule for a ij-th matrix element,
v = [0, 2], i=[1, k], j=[1, k+1],
g⁰ = xᵢ ⊕ e, g¹ = xᵢ ⊕ (-xᵢ), g² = xᵢ ⊕ (-xᵢ) ⊕ (-xᵢ),
e is unity element of Abelian group,
and the decoder is in a form which provides for the exclusion from the vector-row Y'ₙ of the element which corresponds by its number to the additional column of the generating matrix of operations G under the provision that H⊗Y'ₙ^{T}= e, where
Y'ₙ^{T} is transposed vector-row Y'ₙ,
H is 1×(k+1) check matrix of operations generated by transposition of the additional column, by adding operation g⁰ at its right, if the additional column contains a sequence of operations g⁰, and by rearranging the columns identically to the column rearrangement of the generating matrix of operations, or in the same way save for exchanging operations g² for operations g⁰, if the additional column contains a sequence of operations g².

5. The system for transmitting a digital message according to claim 4, **characterized in that** the encoder contains:
- the first operative memory unit, k outputs of which are connected to the corresponding first k information inputs of the second operative memory unit, the output of which forms the encoder output,
- consecutively connected a function g² calculator, the first adder-accumulator of Abelian group elements, the output of which is connected to its second input, the first switch, the output of which is connected to the (k+1)-th information input of the second operative memory unit,
- consecutively connected the first pulse shape forming unit and the first ring counter up to k, the overflow output of which is connected to the control input of the first switch and to the reset input of the first operative memory unit,
- consecutively connected a pulse generator having recurrent frequency of f(k+1)/k, the second switch and the first ring counter up to (k+1), the information output of which is connected to the address input of the second operative memory unit,
- the first gate AND, the output of which is connected to the control input of the second switch,
- the first trigger, the output of which is connected to the direct input of the first gate AND, the inverting input of which is connected to the overflow output of the first ring counter up to (k+1) and to the reset input of the first trigger,
- consecutively connected the first pulse recurrent frequency doubler, the input of which is connected to the output of the pulse generator having recurrent frequency of f(k+1)/k, and a ring counter up to (2k+1), the overflow output of which is connected to the counting input of the first trigger,
and that the combined information inputs of the first operative memory unit and the function g² calculator, the start input of the pulse shape forming unit and the synchronization input of the pulse generator having recurrent frequency of f(k+1)/k together form the encoder input, whereby f is the recurrent frequency of the code word elements in a digital message.

6. The system for transmitting a digital message according to claim 4 or 5, **characterized in that** the decoder contains
- the third operative memory unit, (k+1) outputs of which are connected to the corresponding first (k+1) information inputs of the fourth operative memory unit, the output of which forms the decoder output,
- consecutively connected the second adder-accumulator for Abelian group elements, the output of which is connected to its second input, the third switch, the identification unit for identifying the correspondence to unity element of Abelian group, and the fourth switch, the output of which is connected to the address input of the fourth operative memory unit,
- consecutively connected the second pulse shape forming unit and the second ring counter up to (k+1), the overflow output of which is connected to the control input of the third switch and to the reset input of the third operative memory unit,
- consecutively connected a pulse generator having recurrent frequency of fk/(k+1), the fifth switch, and the second ring counter up to k, the information output of which is connected to the information input of the fourth switch,
- the second gate AND, the output of which is connected to the control input of the fifth switch,
- the second trigger, the output of which is connected to the direct input of the second gate AND, an inverting input of which is connected to the overflow output of the second ring counter up to k and to the reset input of the second trigger,
- consecutively connected the second pulse recurrent frequency doubler, the input of which is connected to the output of the pulse generator having recurrent frequency of fk/(k+1), and the ring counter up to [2(k+1)+1], the overflow output of which is connected to the counting input of the second trigger,
and that the combined information inputs of the third operative memory unit and the second adder-accumulator for Abelian group elements, the start input of the second pulse shape forming unit and the synchronization input of the pulse generator having recurrent frequency of fk/(k+1) together form the decoder input.
